Europäisches Patentamt

European Patent Office

Office européen des brevets

(19)

(11) Veröffentlichungsnummer: **0 194 501**
**A2**

(12) # EUROPÄISCHE PATENTANMELDUNG

(21) Anmeldenummer: 86102432.1

(22) Anmeldetag: 25.02.86

(51) Int. Cl.⁴: **B 67 D 5/02**
**C 30 B 31/16, C 30 B 25/14**

(30) Priorität: 09.03.85 DE 3508543

(43) Veröffentlichungstag der Anmeldung:
17.09.86 Patentblatt 86/38

(84) Benannte Vertragsstaaten:
AT BE CH DE FR GB IT LI NL SE

(71) Anmelder: Merck Patent Gesellschaft mit beschränkter Haftung
Frankfurter Strasse 250
D-6100 Darmstadt(DE)

(72) Erfinder: Harder, Norbert
Steingasse 15a
D-8750 Aschaffenburg(DE)

(72) Erfinder: Berkner, Rolf
Schillerstrasse 32
D-6725 Römerberg 3(DE)

(72) Erfinder: Joseph, Frank
Breslauer Strasse 11a
D-6084 Gernsheim(DE)

(54) Entnahmekopf für Flüssigkeitsbehälter.

(57) Ein geteilter Entnahmekopf (1) zum Anschluß von Flüssigkeitsbehältern (2) an eine Verarbeitungsanlage weist ein Ventiloberteil (3) auf, das mit Rohrleitungen (5) der Anlage verbunden ist. Das Ventiloberteil (3) ist lösbar mit einem Ventilunterteil (11) verschraubt, das mittels einer Anschlußmutter (17) mit dem Flüssigkeitsbehälter (2) verbunden ist. Die Anschlußmutter (17) weist zwei Innengewindeabschnitte (18, 19) mit entgegengesetzter Gangrichtung auf und bildet eine Rechts-Links-Verschraubung, die das Adapterteil (11) mit dem Flüssigkeitsbehälter (2) verbindet.

Der Entnahmekopf (1) wird beispielsweise in Anlagen der Halbleiterfertigung verwendet (Zeichnung).

EP 0 194 501 A2

Merck Patent Gesellschaft
mit beschränkter Haftung

6100  D a r m s t a d t


Entnahmekopf für Flüssigkeitsbehälter

Die Erfindung betrifft einen teilbaren Entnahmekopf für Flüssigkeitsbehälter, die einen Gewindeanschluß mit Außengewinde aufweisen, im wesentlichen bestehend aus einem mit Rohranschlüssen versehenen Ventiloberteil und einem damit in vorgegebener Ausrichtung verbindbaren Ventilunterteil, das mittels einer Anschlußmutter mit dem Außengewinde des Flüssigkeitsbehälters verschraubbar ist.

Derartige Entnahmeköpfe dienen zum Anschluß von austauschbaren Flüssigkeitsbehältern an Verarbeitungsanlagen, in denen das Ventiloberteil über seine Rohranschlüsse mit Rohrleitungen der Anlage in fester Verbindung bleibt.

Ein bevorzugtes Anwendungsgebiet sind je nach Produkt aus Kunststoff, Stahl, Quarz oder Glas bestehende Flüssigkeitsbehälter, die zum Transport, zur Lagerung und zur Entnahme von verdampfbaren Substanzen z.B. für die Halbleiterfertigung bestimmt sind. Da es sich hierbei überwiegend um giftige und/oder aggressive Substanzen handelt, und da Verunreinigungen der Flüssigkeitsbehälter und/oder der angeschlossenen Dotier- oder Epitaxieanlagen zu erheblichen Störungen des Verarbeitungsvorganges führen würden, müssen die Entnahmeköpfe so ausgeführt sein, daß eine sichere und dichte Verbindung in einfacher Weise und mit einfach gestalteten Bauelementen hergestellt werden kann.

Bekannt ist die Verwendung von zweigeteilten Entnahmeköpfen der eingangs genannten Gattung mit einem Kükenventil (DE-GM 83 20 424), bei denen das Anschlußstück über seine Rohranschlüsse mit den Rohrleitungen der Anlage verbunden ist, während das Adapterteil mit dem Flüssigkeitsbehälter verbunden bleibt. Zum Anschluß des Flüssigkeitsbehälters wird das Adapterteil mit dem Anschlußstück verbunden. Da sowohl das Adapterteil als auch das Anschlußstück zwei durchgehende Bohrungen aufweisen, die jeweils fluchtend mit der zugehörigen anderen Bohrung verbunden werden müssen, ist die Verbindung des Anschlußstückes mit dem Adapterteil so ausgeführt, daß eine vorgegebene Ausrichtung dieser beiden Teile zueinander sichergestellt ist. Dies geschieht beispielsweise bei dem bekannten Entnahmekopf durch einen stirnseitig aus dem Anschlußstück herausragenden Zentrierstift, der in eine entsprechende Bohrung in der Stirnfläche des Adapterteils greift. Eine vorgegebene Ausrichtung des Flüssigkeitsbehälters ist damit nicht gewährleistet.

In diesem Zusammenhang ist zu berücksichtigen, daß die verwendeten Flüssigkeitsbehälter üblicherweise an einer Umfangsstelle eine Anschlußmöglichkeit für einen Thermofühler oder ein ähnliches Meßgerät aufweisen. Wenn der Flüssigkeitsbehälter an die Anlage angeschlossen ist, soll sich diese Anschlußstelle in einer bestimmten vorgegebenen Ausrichtung zu den übrigen Teilen der Anlage befinden. Durch diese Maßnahme soll einerseits sichergestellt werden, daß Beschädigungen beispielsweise eines aus dem Flüssigkeitsbehälter nach oben ragenden Thermofühlers oder dergleichen beim Anschließen des Flüssigkeitsbehälters vermieden werden; andererseits ist zu berücksichtigen, daß der Thermofühler oder dergleichen mit einer Steuer- oder Überwachungseinrichtung der Anlage verbunden ist und sich deshalb in einer vorgegebenen Ausrichtung zu dieser befinden soll.

Es ist deshalb erwünscht, das Adapter- bzw. Ventilunterteil nach dem Füllen des Flüssigkeitsbehälters in einer fest vorgegebener Ausrichtung auf den Gewindeanschluß des Flüssigkeitsbehälters anzubringen. Der bereits bekannte Entnahmekopf besteht aus Anschlußstück, Adapterteil und Überwurfmutter, welche das Ventiloberteil mit dem Behälter verbindet. Beim Anziehen der Überwurfmutter sind die am Adapterteil einerseits und am Gewindeanschluß des Flüssigkeitsbehälters andererseits auftretenden Reibungsverhältnisse unterschiedlich, so daß sich das Adapterteil beim Anziehen der Überwurfmutter in nicht genau kontrollierbarer Weise um einen gewissen Winkelbetrag gegenüber dem Flüssigkeitsbehälter verdreht. Deshalb kann die gewünschte vorgegebene Ausrichtung zwischen dem Adapterteil und dem Flüssigkeitsbehälter nicht zuverlässig eingehalten werden.

Außerdem bedingt die Verwendung einer Überwurfmutter bei dem bekannten Entnahmekopf, daß der Durchmesser des Adapterteils oberhalb des von der Überwurfmutter hintergriffenen Flansches keinen radialen Vorsprung mehr aufweisen darf, da anderenfalls die Überwurfmutter bei der Montage nicht aufgesetzt werden könnte. Da aber der Durchmesser des Anschlußstücks schon wegen der darin enthaltenen Bohrungen größer als der Durchmesser des Gewindeanschlusses des Flüssigkeitsbehälters ist, kann bei dem bekannten Entnahmekopf das Anschlußstück nicht unmittelbar mit dem Adapterteil verbunden werden. Eine mit dem Anschlußstück verbundene Überwurfmutter ist deshalb mit einem Gewindeanschluß der Überwurfmutter verbunden, die das Adapterteil mit dem Flüssigkeitsbehälter verbindet und die deshalb verhältnismäßig kompliziert ausgeführt sein muß.

Aufgabe der Erfindung ist es daher, einen Entnahmekopf der eingangs genannten Gattung so auszugestalten, daß unter Verwendung einfach gestalteter Bauteile, insbesondere der das Adapter- bzw. Ventilunterteil mit dem Flüssigkeitsbehälter verbindenden Anschlußmutter, eine sichere, dichte Verbindung mit dem Flüssigkeitsbehälter unter Einhaltung einer vorgegebenen gegenseitigen Ausrichtung sichergestellt ist.

Diese Aufgabe wird erfindungsgemäß dadurch gelöst, daß die Anschlußmutter zwei Innengewindeabschnitte mit entgegengesetzter Gangrichtung aufweist. Die Anschlußmutter ist somit als sogenannte Rechts-Links-Gewindemutter ausgeführt. Die beiden Innengewindeabschnitte werden bei der Verbindung des Ventilunterteils mit dem Flüssigkeitsbehälter gleichzeitig auf die an beiden Teilen vorgesehenen Außengewinde aufgeschraubt. Beim Anziehen der Anschlußmutter zur Herstellung einer dichten Verbindung des Ventilunterteils mit dem Flüssigkeitsbehälter tritt keine unkontrollierte Verdrehung des Entnahmekopfes gegenüber dem Flüssigkeitsbehälter auf, so daß die vorgegebene gegenseitige Ausrichtung sichergestellt ist.

Da die Anschlußmutter von unten her auf das Ventilunterteil aufgeschraubt wird und keinen Flansch übergreift, kann das Ventilunterteil an seinem oberen, zur Verbindung mit dem Ventiloberteil bestimmten Ende mit dem jeweils hierfür geeigneten größeren Durchmesser ausgeführt werden. Alle benutzten Bauteile sind von verhältnismäßig einfacher konstruktiver Gestaltung und daher kostengünstig herzustellen und einfach zu handhaben.

Gemäß einer bevorzugten Ausführungsform der Erfindung haben die beiden Innengewindeabschnitte der Anschlußmutter annähernd gleiche Ganghöhen und vorzugsweise auch gleiche Gewindedurchmesser und gleiches Gewindeprofil, so daß die beim Anziehen auftretenden Reibungsverhältnisse weitgehend gleich sind.

In Weiterbildung des Erfindungsgedankens ist vorgesehen, daß in der unteren Stirnfläche des Ventilunterteils eine O-Ringdichtung in einer stirnseitig offenen Dichtungsnut angeordnet ist. Die O-Ringdichtung stellt beim Anziehen der Anschlußmutter eine sichere und zuverlässige Abdichtung zwischen dem Flüssigkeitsbehälter und dem Ventilunterteil her. Ein weiterer Vorteil in der Ausführungsform des geteilten Entnahmekopfes liegt darin, daß das Oberteil mit allen Schlauchanschlüssen während des Behälterwechsels in der Anlage verbleiben kann und während des Wechselvorganges ständig mit einem Spülgas (z.B Stickstoff) über die angeschlossenen Leitungen durchflutet werden kann. Diese Verfahrensweise schließt eine Verunreinigung des Entnahmekopfes und der Anlage durch Staubteilchen oder Hydrolyseprodukte während des Behälterwechsels aus.

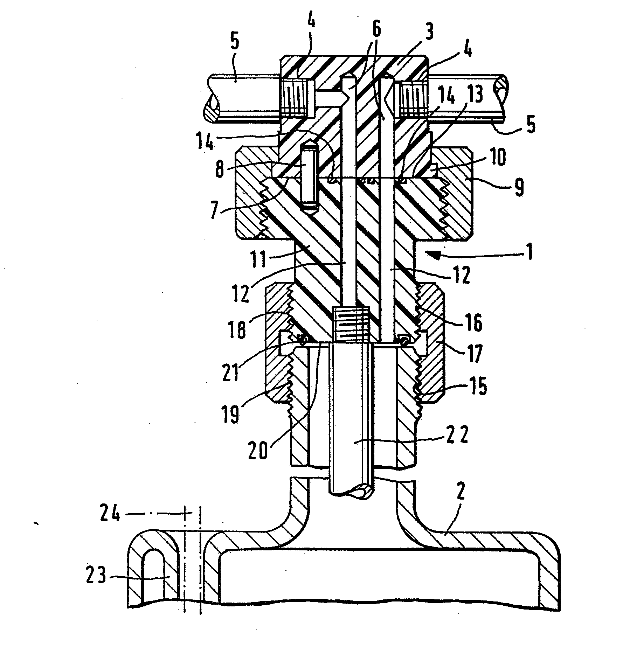

Die Erfindung wird nachfolgend an einem Ausführungsbeispiel näher erläutert, das in der Zeichnung dargestellt ist. Die Zeichnung zeigt in einem senkrechten Schnitt einen geteilten Entnahmekopf (1), der auf einen Flüssigkeitsbehälter (2) aufgesetzt ist. Der Entnahmekopf (1) besteht aus einem Ventiloberteil (3), das über zwei entgegengesetzt angeordnete Rohranschlüsse (4) mit Rohrleitungen (5) einer Verarbeitungsanlage fest verbunden ist, beispielsweise einer Dotieranlage in der Halbleiterfertigung. Mit den Rohranschlüssen (4) in Verbindung stehende innere Bohrungen (6) des Ventiloberteils (3) münden in
einer Stirnfläche (7), aus der auch ein Zentrierstift
ragt, der in eine entsprechende Bohrung des Ventilunterteils (11) eingreift.

Mittels einer Überwurfmutter (9), die einen Flansch (10)
hintergreift, ist das Ventiloberteil (3) mit dem Ventilunterteil (11) verbunden, in dem sich die Bohrungen (6)
in Bohrungen (12) fortsetzen. In der oberen Stirnfläche
(13) des Ventilunterteils (11) dichten in Ringnuten eingelegte O-Ringdichtungen (14) jeweils die Übergänge
zwischen den miteinander fluchtenden Bohrungen (6) und
(12) ab.

Die Entnahme des Flüssigkeitsbehälters (2) mit dem Ventilunterteil (11) aus der Anlage muß wegen des in die
Bohrung des Ventilunterteils (11) eingreifenden Zentrierstifts (8) üblicherweise nach unten erfolgen. In einer
bevorzugten Ausführungsform ist daher die Bohrung im
Ventilunterteil (11) als Schlitz ausgeführt, so daß nach
Lösen der Überwurfmutter (9) das Ventilunterteil (11)
mit Flüssigkeitsbehälter (2) direkt nach vorne entnommen
werden kann. Die Positionierung von Ventiloberteil (3)
und Ventilunterteil (11) bleibt bei dieser Ausführungsform gewahrt.

Der mit dem Ventilunterteil (11) verbundene Flüssigkeitsbehälter (2), beispielsweise eine Glasflasche, weist an
dem Flaschenhals einen Gewindeanschluß, vorzugsweise mit
Außengewinde (15), auf. Ein Außengewinde (16) mit vorzugsweise gleichem Gewindedurchmesser und gleichem Gewindeprofil, jedoch mit entgegengesetzter Gangrichtung ist am
unteren Ende des Ventilunterteils (11) vorgesehen. Eine
Anschlußmutter (17), die zwei Innengewindeabschnitte (18
und 19) mit entgegengesetzter Gangrichtung aufweist, ist
auf die Außengewinde (15 und 16) aufgeschraubt.

In der unteren Stirnfläche (20) des Ventilunterteils (11) ist eine O-Ringdichtung (21) in einer stirnseitig offenen Dichtungsnut angeordnet. Beim Anziehen der Anschlußmutter (17) wird die O-Ringdichtung (21) gegen die obere Stirnfläche des Flüssigkeitsbehälters (2) dichtend angepreßt.

In der Zeichnung ist angedeutet, daß eine der beiden Bohrungen (12) des Adapterteils (11) mit einem in den Flüssigkeitsbehälter (2) ragenden Tauchrohr (22) verbunden ist. Seitlich am Flüssigkeitsbehälter (2) ist eine Tasche (23) zur Aufnahme eines in der Zeichnung nur angedeuteten Thermofühlers (24) vorgesehen.

Beim Verschließen des Flüssigkeitsbehälters (2) nach dem Füllen wird das Ventilunterteil (11) beim Anziehen der Anschlußmutter (17) in einer vorgegebenen Stellung in bezug auf die Tasche (23) aufgebracht. Für die Lagerung und den Transport wird das Ventilunterteil (11) zunächst an seiner Oberseite mittels einer (nicht dargestellten) Verschlußkappe oder Platte verschlossen. Wenn das Ventilunterteil (11) später mit dem Ventiloberteil (3) verbunden wird, befindet sich auch der Flüssigkeitsbhälter (2) in der vorgegebenen gewünschten Ausrichtung zu den Rohranschlüssen (4) des Ventiloberteils (3).

Die Teile des Entnahmekopfes (1) bestehen aus Materialien, die gegen die im Flüssigkeitsbehälter (2) enthaltenen, üblicherweise aggressiven Substanzen resistent sind, vorzugsweise aus Kunststoff.

Merck Patent Gesellschaft
mit beschränkter Haftung

6100  D a r m s t a d t


Ansprüche

1.  Teilbarer Entnahmekopf für Flüssigkeitsbehälter, die
    einen Gewindeanschluß mit Außengewinde aufweisen, im
    wesentlichen bestehend aus einem mit Rohranschlüssen
    versehenen Ventiloberteil und einem damit in vorgegebener Ausrichtung verbindbaren Ventilunterteil, das
    mittels einer Anschlußmutter mit dem Außengewinde
    des Flüssigkeitsbehälters verschraubbar ist, dadurch
    gekennzeichnet, daß die Anschlußmutter (17) zwei
    Innengewindeabschnitte (18, 19) mit entgegengesetzter
    Gangrichtung aufweist.

2.  Entnahmekopf nach Anspruch 1, dadurch gekennzeichnet,
    daß die beiden Innengewindeabschnitte (18, 19) der
    Anschlußmutter (17) annähernd gleiche Ganghöhen
    haben.

3.  Entnahmekopf nach Anspruch 1 oder 2, dadurch gekennzeichnet, daß die beiden Innengewindeabschnitte (18,
    19) der Anschlußmutter (17) annähernd gleiche Gewindedurchmesser und gleiches Gewindeprofil haben.

4.  Entnahmekopf nach einem der Ansprüche 1 bis 3, dadurch gekennzeichnet, daß in der unteren Stirnfläche
    (20) des Ventilunterteils (11) eine O-Ringdichtung
    (21) in einer stirnseitig offenen Dichtungsnut ange-
    ordnet ist.


PAT LOG 7/2 070385

5. Entnahmekopf nach einem der Ansprüche 1 bis 4, dadurch gekennzeichnet, daß im Ventilunterteil (11) ein zur Aufnahme des Zentrierstifts (8) geeigneter Schlitz vorgesehen ist.